# EUROPÄISCHE PATENTANMELDUNG

(11) **EP 0 954 104 A1**
(43) Veröffentlichungstag der Anmeldung: **03.11.1999**
(21) Anmeldenummer: 98107762.1
(22) Anmeldetag: 28.04.1998
(51) Int. Cl.: H03L 7/14, H03L 7/085

(54) **Phasenregelkreis mit analogem Phasenkomparator und digitalem Filter**

(71) Anmelder: SIEMENS AKTIENGESELLSCHAFT, 80333 München (DE)
(72) Erfinder: Korbacher, Richard, Dipl.-Ing. (FH), 82178 Puchheim (DE); De Ceulaer, Bart, Dipl.-Ing., 2200 Noorderwijk (BE); Maes, Guido, Indust,.Ing. (TH), 3945 Ham (BE)

(57) **Zusammenfassung**

Ein Phasenregelkreis, mit einem gesteuerten Oszillator (VCXO), dem als Steuersignal ein von einem analogen Phasenkomparator (PHK) stammendes Signal zugeführt ist, wobei dem Phasenkomparator einerseits das Ausgangssignal eines Vorwärtsteilers (VWT) für das Referenzsignal (s_{ref}) und andererseits das Ausgangssignal eines Rückwärtsteilers (RWT) für das Ausgangssignal (f_{vco}) des gesteuerten Oszillators zugeführt ist, wobei dem Phasenkomparator (PHK) ein Analog-/Digital-Wandler (A/D) nachgeschaltet ist, das digitale Ausgangssignal dieses Wandlers einem digitalen Filter (DLP) zugeführt ist, dem digitalen Filter ein Digital-/Analog-Wandler (D/P) nachgeschaltet ist und dessen Ausgang dem gesteuerten Oszillator zugeführt ist, sodaß der abgespeicherte aktuelle digitale Wert des den Oszillator steuernden Signals bei Ausfall des Referenzsignals im Hold-Over-Betrieb gehalten und dem gesteuerten Oszillator zugeführt wird.

## Beschreibung

Die Erfindung bezieht sich auf ein Verfahren zur Regelung eines gesteuerten Oszillators in einem Phasenregelkreis, bei welchem das Ausgangssignal des gesteuerten Oszillators in einem Phasenkomparator mit einem Referenzsignal verglichen und das Ergebnis dieses Vergleichs dem Oszillator zugeführt wird.

Weiters bezieht sich die Erfindung auf einen Phasenregelkreis mit einem gesteuerten Oszillator, dem als Steuersignal ein von einem analogen Phasenkomparator stammendes Signal zugeführt ist, wobei dem Phasenkomparator einerseits das Ausgangssignal eines Vorwärtsteilers für das Referenzsignal und andererseits das Ausgangssignal eines Rückwärtsteilers für das Ausgangssignal des gesteuerten Oszillators zugeführt ist.

In digitalen Übertragungs- und Vermittlungssystemen müssen sämtliche im Datenfluß befindliche Netzelemente synchronisiert werden. Hierzu werden üblicherweise Phasenregelkreise, nachstehend öfters als PLL (Phase Locked Loop) bezeichnet, benutzt, welche die Frequenz eines lokalen Taktgenerators so nachregeln, daß der lokale Takt bezüglich seiner Frequenz identisch mit dem zugeführten Referenztakt ist, bzw. zu diesem in einem konstanten Verhältnis steht. Die Phasenregelkreise werden je nach Anwendung für bestimmte Eigenschaften optimiert. Mit den bisher üblichen und bekannten Ausführungen von Phasenregelkreisen können eine hohe Frequenzspeichergenauigkeit, d. h. Genauigkeit bei Ausfall des Referenztaktes, und gleichzeitig ein geringer Zeitintervallfehler nicht erreicht werden. Für Taktgeneratoren in Netzwerkelemente von SDH-Netzen (Synchronous Digital Hierarchie) werden aber genau diese Eigenschaften gefordert, was beispielsweise in der Empfehlung ITU G825 enthalten ist.

Solange ein stabiler Referenztakt vorhanden ist, wird der lokale Taktgenerator auf diesen Takt synchronisiert, und er besitzt auf lange Zeit gemittelt die gleiche Frequenz. Die augenblickliche Phasendifferenz zwischen dem Referenztakt und dem lokalen Takt ist jedoch nicht Null und ändert sich mit der Zeit. Der maximale Wert dieser Phasendifferenz über eine bestimmte Meßzeit wird maximaler relativer Zeitintervallfehler (MRTIE) genannt und soll so klein wie möglich sein, im allgemeinen weniger als einige 1.10⁻⁹ s.

Wenn der stabile Referenztakt verloren geht, muß der lokale Takt seine vorhergehen Frequenz mit hoher Genauigkeit halten. Dies entspricht dann dem Hold-over Betrieb ( 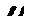 Hold Over") des lokalen Taktgenerators. Der Frequenzfehler bezogen auf den Idealzustand soll dabei so gering wie möglich sein, nämlich in der Größenordnung von 10⁻⁹. Diese Genauigkeit wird als Hold-Over-Genauigkeit bezeichnet.

Allerdings stehen die genannten Anforderungen in Widerspruch zueinander: Ein geringer maximaler, relativer Zeitintervallfehler führt zu einer niedrigen Hold-Over-Genauigkeit und umgekehrt. Die bekannten analogen Lösungen mit integrierenden Filtern zeigen mehrere Nachteile. Bei Verlust des Referenzsignals, in der Referenzfrequenz driftet der Regelkreis weg, sodaß ein genauer Hold-Over Betrieb fast unmöglich wird. Das analoge Filter benötigt auch kostspielige Bauteile, wie Operationsverstärker großer Bandbreite und Kondensatoren mit sehr großen Kapazitätswerten.

Demnach liegt eine Aufgabe der Erfindung darin, eine hohe Hold-Over-Genauigkeit zu erreichen, wobei auch ein geringer maximaler relativer Zeitintervallfehler erhalten bleibt, ohne daß man eine aufwendige und teure Schaltungsanordnung benötigt.

Diese Aufgabe wird mit einem Phasenregelkreis der eingangs genannten Art erreicht, bei welchem erfindungsgemäß das Ausgangssignal des analogen Phasenkomparators in ein digitales Signal umgesetzt wird, das digitale Signal regelungstechnisch verarbeitet und sodann wieder in ein analoges Signal umgesetzt wird, welches dem gesteuerten Oszillator zugeführt wird, wobei die regelungstechnische Verarbeitung ein ständiges Abspeichern des aktuellen digitalen Wertes beinhaltet und dieser Wert bei Ausfall des Referenzsignals im Hold-Over-Betrieb gehalten und dem gesteuerten Oszillator zugeführt wird.

Dank Der Erfindung wird mit geringem Aufwand erreicht, daß der aktuelle Eingangswert des gesteuerten Oszillators praktisch beliebig lange ohne Driftfehler gehalten werden kann.

Dabei ist mit Vorteil vorgesehen, daß die regelungstechnische Verarbeitung des digitalen Signals eine Proportional- und Integral-Aufbereitung beinhaltet. Die entsprechenden, die Art der Verarbeitung bestimmenden Werte können hier auch softwaremäßig vorgegeben bzw. gesteuert werden.

Zur Verwirklichung der Erfindung ist auch bei einem Phasenregelkreis der eingangs genannten Art vorgesehen, daß erfindungsgemäß dem Phasenkomparator ein Analog-/Digital-Wandler nachgeschaltet ist, das digitale Ausgangssignal dieses Wandlers einem digitalen Filter zugeführt ist, dem digitalen Filter ein Digital-/Analog-Wandler nachgeschaltet ist und dessen Ausgang dem gesteuerten Oszillator zugeführt ist. Hierbei ergeben sich die im Zusammenhang mit dem Verfahren genannten Vorteile.

Es ist weiters empfehlenswert, wenn zwischen den Phasenkomparator und das digitale Filter ein analoges Tiefpaßfilter geschaltet ist. Ebenso ist es zweckmäßig, wenn zwischen das digitale Filter und den gesteuerten Oszillator ein analoges Tiefpaßfilter geschaltet ist.

Eine preisgünstige jedoch sehr genau arbeitende Variante zeichnet sich dadurch aus, daß das digitale Filter ein integrierendes Tiefpaßfilter ist.

In diesem Fall empfiehlt es sich, wenn das Ausgangssignal des Phasenkomparators über ein erstes Tiefpaßfilter und einen Spannungskomparator einem ersten auf-/ab-Zähler zugeführt ist, der Ausgang dieses Zählers einem ersten Akkumulator zugeführt ist und dessen Übertrag-Ausgang über ein zweites Tiefpaßfilter dem zweiten Eingang des Spannungskomparators zugeführt ist, der Ausgang des ersten auf/ab-Zählers weiters einem zweiten Addierer zugeführt ist, dessen Ausgang einem zweiten Akkumulator zugeführt ist, wobei der Übertrag-Ausgang des zweiten Akkumulators über ein drittes Tiefpaßfilter dem gesteuerten Oszillator zugeführt ist und ein den Hold-Over-Zustand kennzeichnendes Signal dem reset-Eingang des ersten auf/ab-Zählers zugeführt ist.

Die Erfindung samt weiteren Vorteilen ist im folgenden anhand eines Ausführungsbeispiels und unter Bezugnahme auf die Zeichnung näher erläutert. In dieser zeigen
Fig. 1 eine übliche Phasenregelschleife nach dem Stand der Technik,
Fig. 2 einen Phasenregelkreis nach der Erfindung,
Fig. 3 eine bevorzugte Ausführungsform der Erfindung in einem Blockschaltbild,
Fig. 4 ausgewählte Signalformen in dem Phasenregelkreis nach Fig. 3 und
Fig. 5 die spektrale Verteilung der PWM-PDM-Signale bei einem Phasenregelkreis nach der Erfindung.

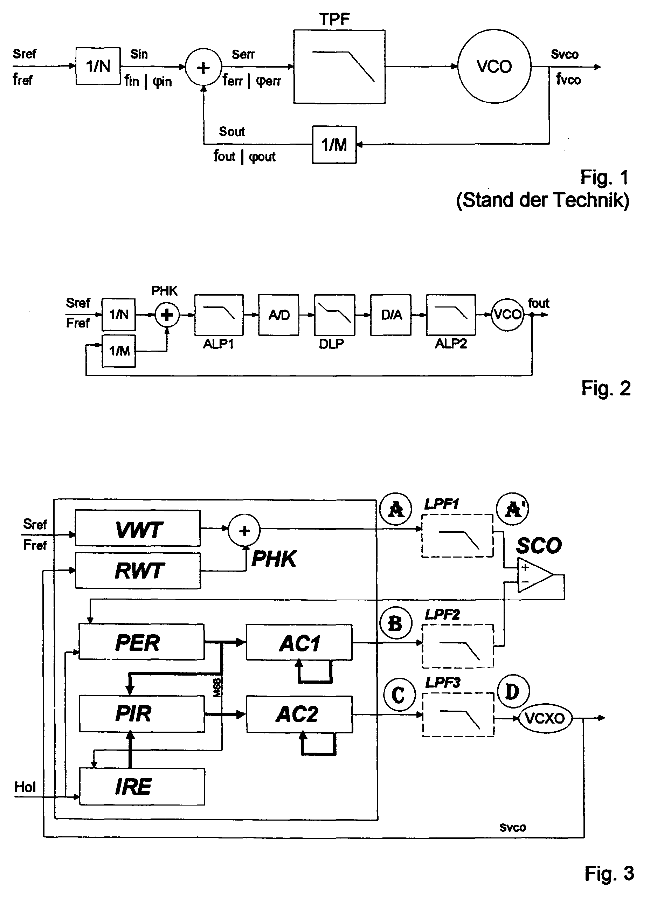

Bevor die eigentliche Erfindung im Detail erläutert wird, sei auf einen üblichen Phasenregelkreis nach dem Stand der Technik eingegangen, der in Fig. 1 skizziert ist. Die Ausgangsfrequenz f_{VCO} wird durch einen spannungsgesteuerten Oszillator VCO erzeugt, welcher bezüglich seiner Phase auf eine Referenzfrequenz f_{ref} synchronisiert ist. Bei diesem Schema ist es im allgemeinen erforderlich, daß sowohl die Referenzfrequenz f_{ref}, als auch die Ausgangsfrequenz f_{VCO} verkleinert werden, beispielsweise um 1/N und 1/M, um gemeinsame Frequenzen f_{IN} und f_{OUT} zu erzeugen, wobei diese Signale s_{IN} und s_{OUT} bzw. Frequenzen f_{IN} und f_{OUT} bezüglich ihrer Phase in einem Phasenkomparator PHK verglichen werden. Hierzu können verschiedene Standardmodule eingesetzt werden, wie beispielsweise ein EXOR-Gatter, doch kann das beschriebene Prinzip auch mit anderen Phasenkomparatoren eingesetzt werden. Zwischen Phasenkomparator PHK und dem Steuereingang des Oszillators VCO ist ein Tiefpaßfilter TPF geschaltet.

Geht man von der Annahme einer idealen Schaltung aus, d.h. es liege z.B. eine perfekte Spannungsversorgung vor, ein VCO ohne Frequenzfehler, ein VCO mit einer nominellen Eingangs-spannung, die gleich 50 % der Versorgungsspannung ist, etc., so werden - falls der Phasenregelkreis ideal synchronisiert ist und die Referenzfrequenz f_{ref} perfekt stabil ist - die Signale s_{IN} und s_{OUT} Rechtecksignale mit einem Tastgrad von 50 %, jedoch um 90 ° phasenverschoben sein. In diesem Fall ist das Ausgangssignal des Phasenkomparators PHK, nämlich das Signal s_{ERR} ein Rechtecksignal mit 50 % Tastgrad, jedoch mit der doppelten Frequenz von f_{IN} oder f_{OUT}. Die Eingangsspannung in den VCO wird 50 % der Versorgungsspannung betragen.

Wenn nun das Signal s_{ref} ausfällt wird das Ausgangssignal des Vergleichers s_{ERR} wiederum ein Rechtecksignal mit 50 % Tastgrad sein, sodaß sich die Eingangsspannung in den VCO nicht ändert, und der Hold-Over Betrieb theoretisch perfekt ist.

In einer realen Schaltung besitzen jedoch sämtliche Komponenten nichtideale Eigenschaften. Falls beispielsweise die nominelle Frequenzabweichung des VCO nicht gleich Null ist, ist zur Synchronisierung des Phasenregelkreises eine Eingangsspannung erforderlich, die leicht unterschiedlich von 50 % der Betriebsspannung ist. Im Ergebnis wird die Phasendifferenz zwischen f_{IN} und f_{OUT} nicht mehr länger 90 ° betragen, sondern etwas mehr oder weniger, und das Signal s_{ERR} wird nicht mehr 50 % Tastgrad besitzen. Somit wird, wenn das Referenzsignal ausfällt, das Ausgangssignal des Phasenkomparators PHK plötzlich zu einem Rechtecksignal mit 50 % Tastgrad werden und die Eingangsspannung des VCO wird sich ändern, wodurch die Genauigkeit im Freilauf sehr schlecht wird.

Offensichtlich kann man eine hohe Genauigkeit im Hold-Over Betrieb nur erreichen, wenn die Eingangsspannung des spannungsgesteuerten Oszillators VCO mit großer Genauigkeit festgehalten wird.

Eine bekannte Lösung, welche diese Forderung erfüllen soll, ist die Verwendung eines integrierenden Schleifenfilters, welche zu einem 50 % Offset zwischen f_{IN} und f_{OUT} führt und theoretisch eine gute Hold-Over-Genauigkeit erlaubt. Da die Schaltung jedoch nicht vollständig ideal ist, wird bei Eintritt in den freilaufenden (Hold-Over-)Betrieb der Tastgrad des Ausgangsignals s_{ERR} des Phasenkomparators PHK nicht genau 50 % betragen, und dieser Offset wird in dem Schleifenfilter integriert, sodaß das Ausgangssignal s_{VCO} wegdriften wird. Die Hold-Over-Genauigkeit ist gering und kann nur mit sehr genauen und daher teuren und kritischen Schaltungskonzepten ein wenig verbessert werden.

Eine andere bekannte Lösung liegt darin, das Signal s_{REF} mit einer hohen Frequenz abzutasten und den EXOR-Komparator durch eine digitale Schaltung zu ersetzen, welche die Lage der Flanken der Signale s_{IN} und s_{OUT} vergleicht. Das Ergebnis dieses Vergleiches wird zum Aktualisieren eines digitalen Registers verwendet, dessen Werte mittels eines Digital/AnalogKonverters in eine Gleichspannung für den Eingang des VCO konvertiert werden. Bei Eintritt in den Hold-Over-Betrieb hält die digitale Schaltung ihre Werte, wodurch die Genauigkeit im Hold-Over-Betrieb sehr hoch ist, der maximale relative Zeitintervallfehler MRTIE jedoch typisch in der Größenordnung einer Periode der Abtastfrequenz liegt. Diese Genauigkeit kann nur durch die Verwendung sehr hohe Abtastfrequenzen erhöht werden, wodurch sich entsprechend teure Schaltungsausführungen ergeben.

Bei der nun folgenden Beschreibung der Erfindung eines Phasenregelkreises mit hoher Hold-Over-Genauigkeit und niedrigen maximalen relativen Zeitintervallfehler MRTIE wird als Beispiel eine Frequenz des spannungsgesteuerten Oszillators VCO mit 51,84 MHz bei einem Abstimmbereich von 12 ppm angenommen, weiters ein Eingangsspannungsbereich zwischen 0,5 V bis 4,5 V und ein Frequenzfehler von 1 ppm. Mit dem in Zusammenhang von Fig. 1 erwähnten VCO kann die Schaltung einen geringen maximalen relativen Zeitintervallfehler aufweisen, jedoch liegt die Hold-Over-Genauigkeit lediglich bei 1 ppm.

Um den guten MRTIE-Wert zu behalten, muß man den analogen Phasenkomparator beibehalten. Der Ausgang des analogen Phasenkomparators wird dann in ein digitales Äquivalent konvertiert, und dieses dazu verwendet, eine Eingangsspannung für den VCO zu erzeugen. Aufgrund der digitalen Steuerung kann man dann eine hohe Hold-Over-Genauigkeit erhalten. Prinzipiell ist dies durch Verwendung üblicher analog/digital- und digital/analog-Konverter erreichbar, doch werden um eine Hold-Over-Genauigkeit von 10⁻⁹ mittels eines VCO zu erreichen, der einen Abstimmbereich von 12 ppm aufweist, zumindest 14 Bit A/D- und D/A-Schaltungen benötigt werden, die verhältnismäßig teuer sind und einen sorgfältigen Aufbau erfordern.

Fig. 2 zeigt den prinzipiellen Aufbau einer Schaltung nach der Erfindung, die sich von der Schaltung gemäß Fig. 1 dadurch unterscheidet, daß zwischen dem Ausgang des auf den analogen Phasenkomparator PHK folgenden Tiefpaßfilters ALP 1 und dem Eingang des gesteuerten Oszillators VCO zunächst ein Analog/Digital-Wandler A/D, sodann ein digitales Filter, z.B. ein digitales, integrierendes Tiefpaßfilter DLP, weiters ein Digital/Analog-Wandler D/A und letztlich ein weiteres analoges Tiefpaßfilter ALP 2 geschaltet ist.

Da die digitale Logik des digitalen Filters DLP das aktuelle Steuersignal für den gesteuerten Oszillator VCO mit hoher Genauigkeit beliebig lange speichern kann, ist ein schwerwiegender Nachteil der bekannten Phasenregelkreise, nämlich das Wegdriften bei Ausfall des Referenzsignals, behoben. Weiters kann bei einer digitalen Logik jede beliebige Filtercharakteristik und ebenso jede beliebige Zeitkonstante verwirklicht werden, wobei überdies eine softwaremäßige Beeinflussung aller Eigenschaften des Filters möglich ist.

Bei der Verwirklichung einer bevorzugten Schaltung ist die Erfindung von folgenden weiteren Überlegungen ausgegangen: Der Ausgang z.B. eines EXOR-Phasenkomparators kann als pulsbreitenmoduliertes (PWM)-Signal betrachtet werden, bei welchem der Tastgrad proportional dem Phasenoffset zwischen f_{IN} und f_{OUT} ist. Eine digitale Schaltung kann jedoch kein PWM-Signal erzeugen, da sie einen festen Takt besitzt, jedoch kann sie ein Pulsdichte-moduliertes (PDM)-Signal erzeugen, bei welchem das durchschnittliche Verhältnis der Ziffern 1 und 0 gleich dem digitalen Wert ist.

Es soll somit ein einfacher und billiger Weg gefunden werden, um die PWM- und PDM-Signale zu vergleichen. Dann können die digitalen Werte in Abhängigkeit von dem Ergebnis des Vergleichs aktualisiert werden, wodurch der analoge Phasenoffset der Phasenregelschleife in einen digitalen Wert konvertiert wird. Dabei ist PWM-Signal der aktuelle Ausgang des analogen EXOR-Phasenkomparators.

Das PDM-Signal wird in folgender Weise erzeugt: Der digitale Wert wird als Eingang eines digitalen Akkumulators verwendet und wenn dieser Akkumulator ein Übertragsausgang (Überlauf) aufweist, wird eine 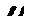 1" ausgegeben, andererseits ist der Ausgang 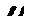 0". Beispielsweise führt ein digitaler Wert von Null immer zu einer 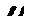 0" an dem Ausgang. Ein maximaler digitaler Wert wird sich immer in einer 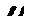 1" an dem Ausgang niederschlagen. Ein digitaler Wert von 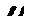 1/2" wird abwechselnd zu 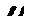 0" und 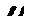 1" führen. Irgendwelche digitalen Werte zwischen 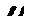 0" und 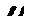 1" werden zu einer pseudostatistischen Sequenz mit im Durchschnitt einer Anzahl von 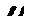 1" führen, der dem digitalen Wert entspricht. Das Prinzip gleicht der Funktion eines Σ-Δ-Modulators: Ein niederfrequentes Signal mit einer Genauigkeit von X Bit wird in ein hochfrequentes Signal mit einer Genauigkeit von 1 Bit konvertiert.

Die PWM- und PDM-Signale werden unter Verwendung eines einfachen passiven RC-Filters erster Ordnung einer Tiefpaßfilterung unterzogen und die Ausgänge dieser Filter werden mit einem preisgünstigen Spannungskomparator verglichen. In Abhängigkeit von dem Ausgang des Spannungskomparators wird die digitale Quelle des PDM-Signals entweder erhöht oder verringert. Sobald sich die Schaltung stabilisiert hat, wird das digitale Register theoretisch das digitale Äquivalent des Phasenfehlers (den Proportionalfehler oder P-Wert) der PLL enthalten.

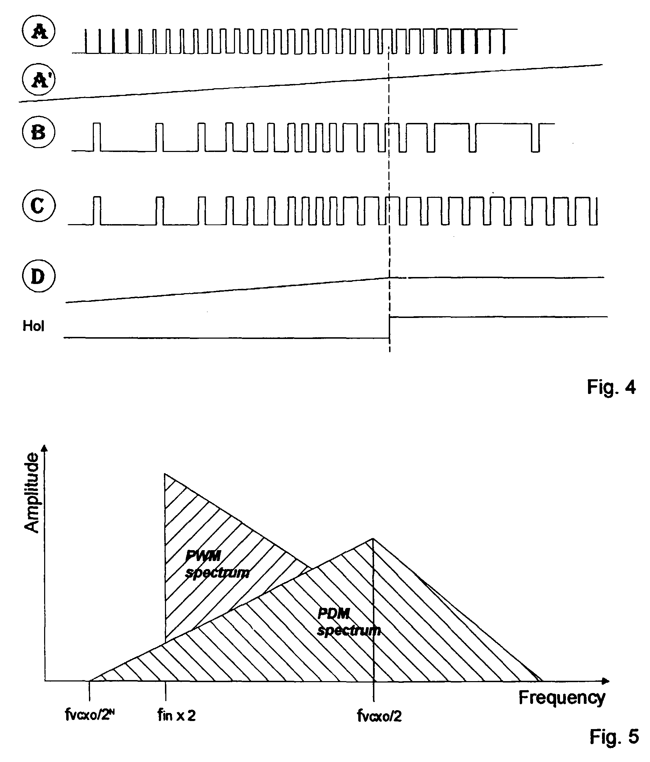

Fig. 3 zeigt den vollständigen Aufbau eines Phasenregelkreises nach der Erfindung, bei welchem die genannten Überlegungen realisiert sind. Oben in Fig. 3 sieht man den üblichen Vorwärtsteiler VWT, dem das Referenzsignal s_{ref} der Frequenz f_{ref} zugeführt wird, sowie einen Rückwärtsteiler RWT, dem das Ausgangssignal s_{VCO} eines spannungsgesteuerten Oszillators VCXO zugeführt ist. Die Ausgangssignale der beiden Teiler werden - ebenso wie nach Fig. 1 - einem Vergleicher, hier einem EXOR-Phasenkomparator PHK, zugeführt. Das entstehende PWM-Signal am Punkt A (siehe Fig. 4) wird in einem Tiefpaßfilter LPF 1 gefiltert. Der digitale Wert in einem P-Register PER wird mit Hilfe eines 16-bit-Akkumulators AG 1 in ein PDM-Signal konvertiert. Dieses an dem Punkt B anliegende Signal wird gleichfalls in einem Tiefpaßfilter LPF 2 einer Filterung unterzogen. Die beiden Tiefpaß-gefilterten Signale der Punkte A und B werden in einem Spannungskomparator SCO verglichen und dessen Ausgang wird zum Aktualisieren dem P-Register PER, einem 16-bit auf/ab-Zähler, zugeführt.

Das Vorzeichen MSB des P-Registers PER wird dazu verwendet, ein wesentlich längeres I-Register IRE, ein 32-bit auf/ab-Zähler, zu aktualisieren. Die P- und I-Werte der Register PER und IRE werden in einem PI-Register PIR, einem 16-bit-Addierer, addiert, und diese Summe wird nun gleichfalls in ein PDM-Signal konvertiert, wozu ein Akkumulator AC2, wiederum ein 16-bit-Akkumulator, vorgesehen ist. Das an dem Punkt C, dem Ausgang des Akkumulators AC2, anstehende Signal wird als Eingangssignal des spannungsgesteuerten Oszillators VCXO verwendet. Bei Eintritt des Hold-Over-Zustandes setzt ein Signal hol das P-Register PER zurück und versperrt das I-Register IRE.

Aus Fig. 4 sieht man, daß das am Punkt A liegende Signal, welches nach dem Tiefpaßfilter LPF1 am Punkt A' eine langsam ansteigende Gerade ist, in ein PDM-Signal (Punkt B) umgewandelt wird. Geht man zur Vereinfachung von einem Integratorwert 0 in der Figur aus, wird ein PDM-Signal am Punkt B an den Punkt C, dem Ausgang des Akkumulators AC2, repliziert. Sobald das Hold-Over-Steuerungssignal, nämlich das Signal hol aktiv wird, wobei dieser Zeitpunkt durch eine gestrichelte Linie in Fig. 4 angedeutet ist, wird das PDM-Signal an dem Punkt C 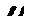 eingefroren", sodaß die analoge Ausgangsspannung am Punkt D auch für sehr lange Freilauf-(Hold-Over-)Zeiten konstant bleibt. Ein zusätzlicher Vorteil der Erfindung liegt wie bereits erwähnt darin, daß eine externe Steuerung der digitalen Proportional (P)- und Integral (I)-Register softwaremäßig möglich ist, sodaß im Prinzip jeder Algorithmus und jede Filtercharakteristik realisierbar ist.

Die Hold-Over-Genauigkeit hängt natürlich von der Stabilität der Spannungsversorgung sowie von der Temperatur ab. Um den Einfluß auf den spannungsgesteuerten Oszillator zu verringern, wird einerseits ein spannungsgesteuerter Quarzoszillator verwendet, der vorteilhafterweise als ofenstabilisierter Oszillator ausgebildet ist. Um andererseits den Einfluß über die Spannungsversorgung zu verringern, können die PWM- und PDM-Signale mit Hilfe zusätzlicher Gatter außerhalb der Hauptkomponenten gepuffert werden, und die Spannungsversorgung für diese Puffer kann dann z.B. mittels eines Parallelreglers erfolgen.

Der Spannungskomparator muß im allgemeinen keine spezielle Ausführung sein. Die PWM- und PDM-Signale werden verglichen und führen entweder zu einer Null oder zu einer Eins am Ausgang des Spannungskomparators. Daraus resultierend wird das P-Register PER entweder inkrementiert oder dekrementiert, bis der Spannungskomparatorausgang hin und her schaltet. Dieser Vorgang wiederholt sich und verleiht dem P-Registerwert eine Sägezahnform.

Falls der durchschnittliche Wert des P-Register PER nicht genau gleich Null ist, wird das I-Register IRE diesen Offset integrieren. Als Wirkung der vollständigen PLL-Schleife ergibt sich, daß das I-Register IRE einen solchen Wert annimmt, daß der P-Registerwert im Mittel exakt Null ist.

Bei Eintritt des Hold-Over-Zustandes wird das I-Register IRE gesperrt und das P-Register PER rückgesetzt. Da sich das P-Register im Durchschnitt tatsächlich auf Null befunden hat, wird sich die ermittelte Summe des P- und des I-Registers nicht ändern. Auf diese Weise erreicht man eine Genauigkeit im Hold-Over-Betrieb, die praktisch unabhängig von der Genauigkeit des Spannungskomparators ist, was zusammen mit den preisgünstigen RC-Filtern zu einer sehr billig realisierbaren Phasenregelschleife führt.

Die Konvertierung PWM zu PDM bildet de facto einen Kreis innerhalb des PLL-Kreises. Die Schnelligkeit des Spannungskomparators und die Breite des P-Registers bestimmen die Bandbreite dieses inneren Kreises. Dabei ist zu beachten, daß die Bandbreite des inneren Kreises zumindest zehn Mal größer ist als jene des äußeren Kreises Ist dies nicht der Fall, so kämen die Pole des inneren Kreises sehr nahe zu den Polen des äußeren Kreises, wobei Spitzen in der Jitter-Übertragungskurve der Phasenregelschleife entstünden.

Die innere Schleife ist im wesentlichen nicht linear, und der Spannungskomparator SCO kann lediglich ein 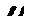 0" oder 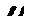 1" ausgeben, sodaß das Rückkoppelsignal nicht proportional dem Rückspeisefehler des Kreises ist. Dies ist allerdings nicht wesentlich, da der äußere Kreis den vollständigen Phasenregelkreis linearisiert, solange das oben angegebene Erfordernis an die Bandbreiten erfüllt wird.

Bezüglich der Dimensionierung des P- und des I-Registers PER bzw. IRE ist auszuführen, daß das I-Register IRE lang genug sein muß, sodaß der in dem PI-Addierer verwendete Wert sich während einer Periode des Sägezahnsignals des P-Register PER um nicht mehr als ein LSB ändert. Bei einer Ausführung mit einem 16-Bit P-Register und einem 16-Bit PI-Addierer muß das I-Register IRE beispielsweise zumindest 32 Bit lang sein. Anderenfalls würde der Wert des I-Registers (16 MSB) gleichfalls beginnen, eine Sägezahnform zu zeigen, und die Genauigkeit im Hold-Over-Betrieb würde unter 16 Bit sinken.

Das Addieren des P- und des I-Wertes kann auf zwei unterschiedliche Arten erfolgen, wobei beide 50 % des gesamten digitalen Bereiches oder auch 100 % nutzen können.

Der P-Wert ist die augenblickliche Reaktion des Phasenregelkreises auf einen Eingangsphasenfehler, wogegen der I-Wert die Langzeitreaktion des Phasenregelkreises auf einen Frequenzfehler ist. Demnach definiert der P-Bereich die Jitter-Toleranz des Phasenregelkreises, und der I-Bereich definiert den Frequenz-Abstimmbereich.

Teilt man beiden 100 % des Bereiches zu, so wird das P-Register einen Wert zur Kompensation eines Eingangs-Jitter annehmen, und das I-Register wird einen Wert zur Kompensation eines Frequenzfehlers annehmen. Solange die Summe von P und I nicht mehr als 100 % oder weniger als 0 % ausmacht, tritt kein Problem auf. Falls diese Summe jedoch 100 % oder 0 % übersteigt, entsteht eine Begrenzung, d.h. der Phasenregelkreis kann entweder mehr Eingangs-Jitter oder mehr Frequenzfehler verarbeiten, wird jedoch versagen, wenn ein merklicher Anteil von beiden vorhanden ist.

Teilt man beiden 50 % des Bereiches zu, so sind sowohl die maximale Jitter-Toleranz als auch der maximale Frequenzfehler begrenzt, jedoch können andererseits Jitter sowie Frequenzfehler immer im Rahmen ihrer 50 % eliminiert werden ohne daß sie einander beeinträchtigen.

Zur Dimensionierung der RC-Filter ist zu sagen, daß bei einem üblichen Phasenregelkreis das PWM-Signal (entsprechend dem Punkt A) einem (integrierenden) Tiefpaßfilter zugeführt wird. Unter der Annahme eines stabilen Eingangs ist dieses Signal ein Rechteck mit 50 % Tastgrad und einer Frequenz gleich 2 f_{IN}. Das Spektrum dieses Signals weist eine Hauptspektrallinie bei 2 · f_{IN} auf und niedrigere Spitzen bei allen ungeradzahligen Vielfachen davon.

Im Gegensatz dazu wird bei der vorliegenden Erfindung, ausgehend von einem stabilen Phasenregelkreis, das PDM-Signal als Eingangssignal der passiven RC-Filter verwendet. Das Spektrum des PDM-Signals hängt von dem PI-Wert ab. Falls PI = 50 %, so ist das Signal am Punkt C, somit am Eingang des dem spannungsgesteuerten Oszillators VCXO vorgelagerten Tiefpaßfilters LPF1, ein Rechteck mit der Frequenz f_{VCXO}/2. Das Spektrum dieses Signals besitzt eine Hauptspektrallinie bei f_{VCXO}/2 und Spektrallinien geringerer Amplitude bei allen ungeradzahligen Vielfachen davon. Für von 50 % verschiedene PI-Werte beginnen auch niedrigere Harmonische aufzuscheinen, nämlich bei allen Vielfachen von f_{VCXO}/2^{N}, wobei N die Breite des PI-Registers bedeutet. Beispielsweise werden für eine Frequenz des spannungsgesteuerten Oszillators VCXO von 51,84 MHz und ein 16-Bit PI-Register PIR niedrigere harmonische bis zu 791 Hz auftreten. Jedoch ist die Amplitude dieser niedrigeren Harmonischen typischerweise wesentlich geringer, als jene der höheren harmonischen. Da meistens die Frequenz f_{VCXO} wesentlich höher als die Eingangsfrequenz f_{IN} ist, liegt der gesamte Frequenzgehalt des PDM-Signals wesentlich höher als jeder des PMW-Signals.

In Fig. 5 ist dementsprechend für ein Beispiel die spektrale Verteilung der PDM- und PWM-Signale gezeigt. Ein Vorteil der Verwendung des PDM-Signals liegt somit auch darin, daß die Bandbreite des RC-Filters, welches das Schleifenfilter des Phasenregelkreises ist, viel höher sein kann, wodurch sich beim Entwurf des gesamten Phasenregelkreises eine größere Freiheit ergibt.

## Patentansprüche

1. Verfahren zur Regelung eines gesteuerten Oszillators in einem Phasenregelkreis, bei welchem das Ausgangssignal des gesteuerten Oszillators in einem Phasenkomparator mit einem Referenzsignal verglichen und das Ergebnis dieses Vergleichs dem Oszillator zugeführt wird,
**dadurch gekennzeichnet**,
daß das Ausgangssignal des analogen Phasenkomparators in ein digitales Signal umgesetzt wird, das digitale Signal regelungstechnisch verarbeitet und sodann wieder in ein analoges Signal umgesetzt wird, welches dem gesteuerten Oszillator zugeführt wird, wobei die regelungstechnische Verarbeitung ein ständiges Abspeichern des aktuellen digitalen Wertes beinhaltet, und dieser Wert bei Ausfall des Referenzsignals im Hold-Over-Betrieb gehalten und dem gesteuerten Oszillator zugeführt wird.

2. Verfahren nach Anspruch 1, **dadurch gekennzeichnet**, daß die regelungstechnische Verarbeitung des digitalen Signals eine Proportional- und Integral-Aufbereitung beinhaltet.

3. Phasenregelkreis, mit einem gesteuerten Oszillator (VCXO), dem als Steuersignal ein von einem analogen Phasenkomparator (PHK) stammendes Signal zugeführt ist, wobei dem Phasenkomparator einerseits das Ausgangssignal eines Vorwärtsteilers (VWT) für das Referenzsignal (s_{ref}) und andererseits das Ausgangssignal eines Rückwärtsteilers (RWT) für das Ausgangssignal (f_{vco}) des gesteuerten Oszillators zugeführt ist,
**dadurch gekennzeichnet**,
daß dem Phasenkomparator (PHK) ein Analog-/Digital-Wandler (A/D) nachgeschaltet ist, das digitale Ausgangssignal dieses Wandlers einem digitalen Filter (DLP) zugeführt ist, dem digitalen Filter ein Digital-/Analog-Wandler (D/P) nachgeschaltet ist und dessen Ausgang dem gesteuerten Oszillator zugeführt ist.

4. Phasenregelkreis nach Anspruch 3, **dadurch gekennzeichnet**, daß zwischen den Phasenkomparator (PHK) und das digitale Filter (DLP) ein analoges Tiefpaßfilter (ALP 1) geschaltet ist.

5. Phasenregelkreis nach den Ansprüchen 3 oder 4, **dadurch gekennzeichnet**, daß zwischen das digitale Filter (DLP) und den gesteuerten Oszillator (VCO) ein analoges Tiefpaßfilter (ALP 2) geschaltet ist.

6. Phasenregelkreis nach einem der Ansprüche 3 bis 5, **dadurch gekennzeichnet**, daß das digitale Filter (DLP) ein integrierendes Tiefpaßfilter ist.

7. Phasenregelkreis nach einem der Ansprüche 3 bis 6, **dadurch gekennzeichnet**, daß das Ausgangssignal des Phasenkomparators (PHK) über ein erstes Tiefpaßfilter (LPF 1) und einen Spannungskomparator (SCO) einem ersten auf-/ab-Zähler (PER) zugeführt ist, der Ausgang dieses Zählers einem ersten Akkumulator (AC 1) zugeführt ist und dessen ÜbertragAusgang über ein zweites Tiefpaßfilter (LPF 2) dem zweiten Eingang des Spannungskomparators (SCO) zugeführt ist, der Ausgang des ersten auf-/ab-Zählers (PER) weiters einem zweiten Addierer (PIR) zugeführt ist, dessen Ausgang einem zweiten Akkumulator (AC 2) zugeführt ist, wobei der ÜbertragAusgang des zweiten Akkumulators über ein drittes Tiefpaßfilter (LPF 3) dem gesteuerten Oszillator (VCXO) zugeführt ist und ein den Hold-Over-Zustand kennzeichnendes Signal (hol) dem reset-Eingang des ersten auf-/ab-Zählers (PER) zugeführt ist.

8. Phasenregelkreis nach Anspruch 7, **dadurch gekennzeichnet**, daß der MSB-Ausgang des ersten auf-/ab-Zählers (PER) dem Eingang eines zweiten auf-/ab-Zählers (IRE) zugeführt ist, dessen Ausgang gleichfalls dem zweiten Addierer (PIR) zugeführt ist und dessen hold-Eingang das dem Holdover-Zustand kennzeichnende Signal (hol) zugeführt ist.
